# EUROPEAN PATENT APPLICATION

(11) **EP 4 030 213 A1**
(43) Date of publication of application: **20.07.2022**
(21) Application number: 22150648.8
(22) Date of filing: 10.01.2022
(51) Int. Cl.: G02B 7/02, C23C 14/50, G02B 7/10

(54) **OPTICAL ELEMENT HOLDER, OPTICAL ELEMENT HOLDING DEVICE, AND VAPOR DEPOSITION APPARATUS**

(30) Priority: 18.01.2021 JP 2021005650
(71) Applicant: Hoya Lens Thailand Ltd., Pathumthani 12130 (TH)
(72) Inventor: SHIMIZU, Hiroshi, Tokyo (JP)
(74) Representative: Betten & Resch

(57) **Abstract**

Provided is an optical element holder which makes it possible to demount an optical element such as a lens therefrom without taking a lot of time and effort.

[Solution]

A lens holder 30 for holding a lens 50 comprises: a frame 32; a lens holding part attached to the frame 32 and configured to hold the lens 50; and a holder mounting part (34, 35) attached to the frame 32 and formed of a magnet-attractable material, wherein the lens holder 30 is mountable to a pallet 16 comprising a pallet-side mounting part formed of a magnet 26, by a magnetic force between the holder mounting part (34, 35) and the pallet-side mounting part.

## Description

### TECHNICAL FIELD

The present disclosure relates to an optical element holder, an optical element holding device, and a vapor deposition apparatus.

### BACKGROUND ART

In order to prevent reflection, scratches, etc., on an optical element such as a lens, a technique of forming a thin film on the surface of the optical element is conducted. For example, a vacuum vapor deposition method and sputtering film formation are known as the thin-film forming technique. In the vacuum vapor deposition method, in a state in which a vapor deposition material is vaporized within a vacuumized container, and a lens is held by a lens holding device, the vaporized vapor deposition material is adhered onto the surface of a glass substrate, while an ion beam is emitted thereinto, as needed, thereby forming a thin film.

As a lens-dedicated vapor deposition apparatus used for such various film forming methods, for example, the below-mentioned Patent Document 1 describes an apparatus comprising a plurality of lens holder units mounted in a circumferential direction, wherein each of the lens holder units comprises a lens holder having an opening, and further mentions a lens holding method using three elastically holding mechanisms provided, respectively, at three equally spaced positions around an opening-defining portion of the lens holder. In the method mentioned in the Patent Document 1, the lens holder is fixed to a base plate which is mounted to a frame by means of a pin and a screw (see paragraphs [0045] and [0047] of the Patent Document 1).

### CITATION LIST

### [Patent Document]

Patent Document 1: JP-B 3084020

### SUMMARY OF DISCLOSURE

### [Technical Problem]

If a pin and a screw are used for mounting or demounting of the lens holder, it would take a lot of time and effort. Further, in the method using a pin and a screw during mounting of the lens holder, a vapor deposition material adhered onto these members can be scraped to generate dust, and the dust is likely to adhere onto a lens.

The present disclosure has been made in view of the above problems, and an object thereof is to, in a device for holding an optical element such as a lens to be subjected to a film forming process, make it possible to prevent dust generation, and demount an optical element holder of the device without taking a lot of time and effort.

### [Solution to Technical Problem]

The present disclosure provides an optical element holder (hereinafter also referred to as "holder") for holding an optical element, comprising: a holder body; an optical element holding part provided on the holder body and configured to hold the optical element; and a holder mounting part provided on the holder body and formed of one of a magnet and a magnet-attractable material, wherein the holder is attachable to a pallet comprising a pallet-side mounting part formed of other of the magnet and the magnet-attractable material, by a magnetic force between the holder mounting part and the pallet-side mounting part.

The present disclosure provides a method of forming a desired film on a surface of an optical element by using an optical element holding device, wherein the optical element holding device comprises: an optical element holder comprising a holder body, an optical element holding part provided on the holder body and configured to hold the optical element, and a holder mounting part provided on the holder body and formed of one of a magnet and a magnet-attractable material; and a pallet comprising a pallet-side mounting part formed of other of the magnet and the magnet-attractable material, the method comprising: an optical element mounting step of mounting the optical element to the holder by the optical element holding part; a first holder mounting step of mounting the holder to the pallet by a magnetic force between the holder mounting part and the pallet-side mounting part; and a first film forming step of applying film forming process to the optical element.

The above film forming process may be a vapor deposition process.

### [Effect of Disclosure]

In the device for holding an optical element such as a lens to be subjected to a film forming process, the present disclosure makes it possible to prevent dust generation, and demount the holder without taking a lot of time and effort.

### BRIEF DESCRIPTION OF DRAWINGS

FIG. 1 is a schematic diagram showing the configuration of a vapor deposition apparatus according to a first embodiment of the present disclosure.
FIG. 2 is a perspective view showing the configurations of a pallet and a holder in the vapor deposition apparatus illustrated in FIG. 1.
FIG. 3 is a perspective view showing a pallet body of the pallet illustrated in FIG. 2.
FIG. 4A is a perspective view enlargedly showing the holder illustrated in FIG. 2.
FIG. 4B is a side view enlargedly showing the holder illustrated in FIG. 2.
FIG. 5 is a flowchart showing the flow of the operation of subjecting a lens to a film forming process by the vapor deposition apparatus according to the first embodiment.
FIG. 6A is a perspective view enlargedly showing a state in which a lens is attached to the holder illustrated in FIG. 2.
FIG. 6B is a side view enlargedly showing the state in which the lens is attached to the holder illustrated in FIG. 2.
FIG. 7 is a perspective view showing how the holder is attached to the pallet in the vapor deposition apparatus according to the first embodiment of the present disclosure.
FIG. 8 is a plan view showing how the holder is demounted from the pallet in the vapor deposition apparatus according to the first embodiment of the present disclosure.
FIG. 9A is a perspective view enlargedly showing a holder to be used in a vapor deposition apparatus according to a second embodiment of the present disclosure.
FIG. 9B is a side view enlargedly showing the holder to be used in the vapor deposition apparatus according to the second embodiment.
FIG. 10 is a flowchart showing the flow of the operation of subjecting a lens to a film forming process by the vapor deposition apparatus according to the second embodiment.

### DESCRIPTION OF EMBODIMENTS

### < First Embodiment >

With reference to the drawings, a lens holder, a lens holding device and a vapor deposition apparatus according to a first embodiment of the present disclosure will now be described in detail.

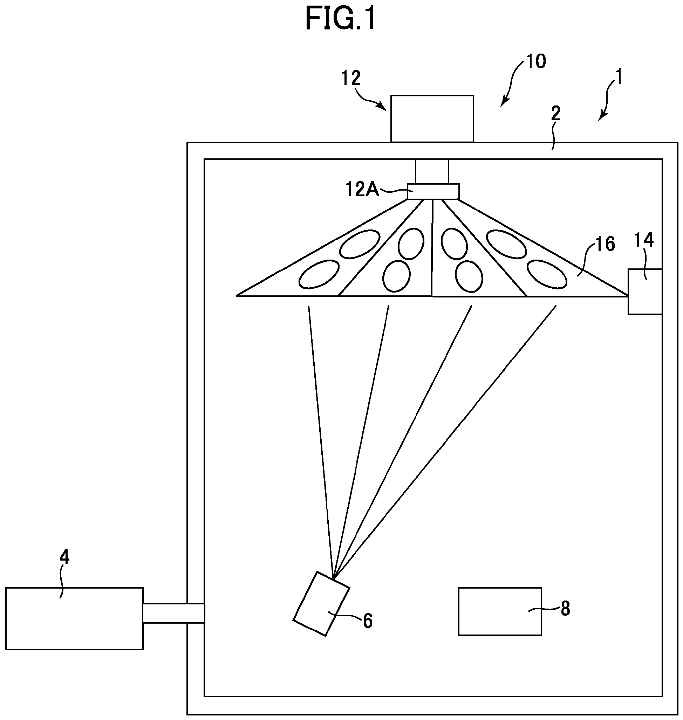

The vapor deposition apparatus according to the first embodiment is designed to vacuum vapor deposit a protective layer (coating), an anti-reflection layer (coating) or a water-repellent layer (coating) onto a spectacle lens as an optical element. FIG. 1 is a schematic diagram showing the configuration of the vapor deposition apparatus according to the first embodiment of the present disclosure. As shown in FIG. 1, the vapor deposition apparatus 1 comprises a chamber 2, a vacuum pump 4 connected to the chamber 2, an ion gun 6, a material vaporization device 8, and a lens holding device 10. It should be noted that, in FIG. 1, the pallets of the pallet holding device 10 are illustrated less than actual in terms of number, for the purpose of illustration.

The chamber 2 is composed of a gastightly-formed housing. Although not illustrated, the chamber 2 is provided with an opening and a door for installing the holder to the lens holding device 10.

The vacuum pump 4 is connected to a side portion of the chamber 2, and configured to evacuate gas from the inside to the outside of the chamber 2, thereby reducing the air pressure in the chamber 2 so as to approach nearly a vacuum state. This makes it possible to lower the vaporization temperature of a vapor deposition material (a material to be vapor deposited), and prevent collision of the vapor deposition material with gas molecules in the chamber 2, which collision hindering the vapor deposition material from adhering to a lens.

The material vaporization device 8 is configured to heat the vapor deposition material, e.g., SiO₂ or Ta₂O₅, to vaporize (gasify or sublimate) the vapor deposition material. The vapor deposition material vaporized by the material vaporization device 8 fills the inside of the chamber 2. As a method to vaporize the vapor deposition material in the material vaporization device 8, it is possible to use, e.g., a method which comprises irradiate the vapor deposition material with an ion beam from an ion gun, thereby heating the vapor deposition material, or a method which comprises heating the vapor deposition material by a heater or the like.

The ion gun 6 is configured to emit an ion beam toward the after-mentioned pallets 16 of the lens holding device 10 through the vaporized vapor deposition material from the material vaporization device 8. This makes it possible to allow the vaporized vapor deposition material from the material vaporization device 8 to tightly adhere to the surface of a lens 50 held by the lens holding device 10 and form a thin film made of the vapor deposition material.

The lens holding device 10 comprises a turning device 12 installed to a ceiling wall of the chamber 2, a plurality of pallets 16 each held in the chamber 2 by the turning device 12, and an inverting device 14 installed to the side portion of the chamber 2.

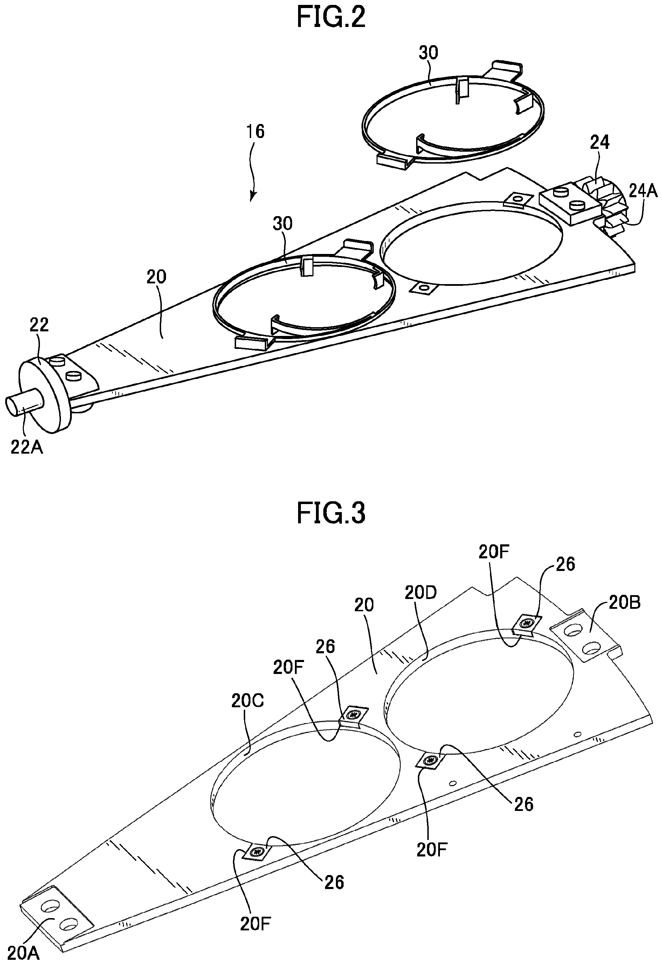

FIG. 2 is a perspective view showing the configurations of the pallet and the holder in the vapor deposition apparatus illustrated in FIG. 1. As shown in FIG. 2, the pallet 16 comprises a pallet body 20 formed in an approximately isosceles triangular shape, a first shaft member 22 mounted to a vertex angle-side end of the pallet body 20, and a second shaft member 24 mounted to the middle of the base of the pallet body 20. A holder 30 for holding the lens 50 can be mounted to and demounted from the pallet 16.

FIG. 3 is a perspective view showing the pallet body of the pallet illustrated in FIG. 2. As shown in FIG. 3, the pallet body 20 is a plate-like member formed in an approximately isosceles triangular shape, and made of, e.g., a non-magnetic material such as SUS 303. A first mounting part 20A is formed at the vertex angle-side end of the pallet body 20, and a second mounting part 20B is formed in the middle of the base of the pallet body 20. Each of the first mounting part 20A and the second mounting part 20B is a portion for allowing a respective one of the first shaft member 22 and the second shaft member 24 to be fixed thereto, and formed with an opening for allowing a bolt to penetrate therethrough.

Further, the pallet body 20 is formed with a first opening 20C and a second opening 20D each having a round shape. The first and second openings 20C, 20D may have the same diameter, or may have different diameters. Respective centers of the first and second openings 20C, 20D are located on a bisector of the vertex angle.

A peripheral edge region defining each of the first and second openings 20C, 20D of the pallet body 20 is formed with a pair of recesses 20F at respective positions opposed to each other across the center of the opening, and a magnet 26 serving as a pallet-side mounting part is fixed to each of the recesses 20F via bolted connection, adhesive bonding or the like. Each of the recesses 20F has a rectangular parallelepiped shape, and the magnet 26 has a rectangular parallelepiped shape corresponding to the shape of the recess 20F. As the magnet 26, it is desirable to use a magnet having heat resistance to 100°C or more, and it is possible to use, e.g., a neodymium magnet. The surface of the magnet 26 is flush with the surface of the pallet body 20.

The first shaft member 22 is bolted to the first mounting part 20A of the pallet body 20. The first shaft member 22 comprises a shaft part 22A. The first shaft member 22 is mounted such that a central axis of the shaft part 22A is located on an extension of the bisector of the vertex angle passing through the through-thickness center of the pallet body 20 (the bisector will hereinafter be referred to as "axis ").

The second shaft member 24 is bolted to the second mounting part 20B of the pallet body 20. The second shaft member 24 comprises a gear part 24A whose outer periphery is formed with teeth. The second shaft member 24 is mounted such that a central axis of the gear part 24A is located on an extension of the axis of the pallet body 20.

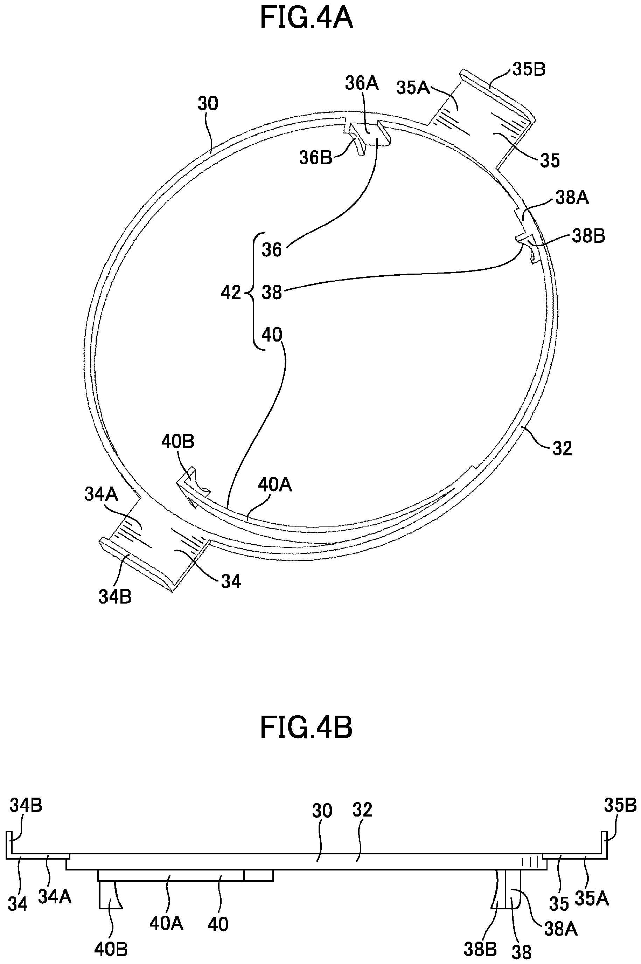

FIG. 4A and FIG. 4B are, respectively, a perspective view and a side view each enlargedly showing the holder illustrated in FIG. 2. As shown in FIGS. 4A and 4B, the holder 30 comprises a circular annular-shaped frame 32, a pair of holder mounting parts 34, 35 each projectingly provided on a radially outer surface of the frame 32, and a lens holding mechanism 42. The holder 30 is formed of a magnetic material or a magnet-attractable material (material attractable by a magnet), such as SUS 430. It should be noted here that, although the holder 30 in this embodiment is entirely formed of a magnetic material, it is only necessary to form at least the holder mounting parts 34, 35 using a magnetic material.

The frame 32 is formed in a circular annular shape whose outer diameter is slightly less than the diameter of each of the first and second openings 20C, 20D of the pallet body 20. In the case where the first and second openings 20C, 20D have different diameters, two types of holders each compatible with a respective one of the openings may be used.

The pair of holder mounting parts 34, 35 are provided on an outer peripheral surface of the frame 32 at respective positions opposed to each other across the center of the frame 32. Each of the holder mounting parts 34, 35 has a flat portion 34A, 35A extending flatly in a radial direction of the frame 32, and a manipulatable portion 34B, 35B standingly provided on a radially outward area of the flat portion 34A, 35A. The flat portion 34A, 35A is formed such that an upper surface (upper surface in FIG. 4B) thereof is flush with an upper surface of the frame 32. The manipulatable portion 34B, 35B is formed by bending a radially outward end of the flat portion 34A, 35A vertically upwardly. Thus, in a state in which the holder 30 is mounted to the pallet 16, the manipulatable portion 34B, 35B takes a posture where it extends in a direction intersecting a flat surface of the pallet body 20.

The lens holding mechanism 42 comprises a first holding member 36, a second holding member 38, and a third holding member 40.

The first holding member 36 and the second holding member 38 are provided on an inner peripheral surface of the frame 32 at respective positions corresponding to circumferential both sides of one 35 of the holder mounting parts. Each of the first and second holding members 36, 38 comprises an attachment part 36A, 38A formed in a curved shape along the frame 32, and an engagement part 36B, 38B provided on a circumferential end of the attachment part 36A, 38A to project radially inwardly. Each of the first and second holding members 36, 38 has a thickness greater than that of the frame 32, wherein each of the first and second holding members 36, 38 is attached to the frame 32 such that an upper surface thereof is flush with the upper surface of the frame 32. A radially-inward end of the engagement part 36B, 38B is formed as an arc-shaped recess whose through-thickness center is concaved radially outwardly. The recess of the engagement part 36B, 38B is formed symmetrically with respect to a symmetrical axis passing through the center in thickness direction. Each of the first and second holding members 36, 38 is attached to the frame 32 such that, when the holder 30 is mounted to each of the first opening 20C and the second opening 20D of the pallet body 20, the symmetrical axis of the engagement part 36B, 38B and the axis of the pallet body 20 are located on the same plane.

The third holding member 40 comprises a resilient part 40A whose one end is fixed to the inner peripheral surface of the frame 32, and an engagement part 40B provided at the other end of the resilient part 40A to project radially inwardly. The resilient part 40A has a thickness greater than that of the frame 32, and the engagement part 40B has a thickness which is greater than that of the frame 32 and equal to that of each of the engagement parts 36B, 38B of the first and second holding members 36, 38. An upper surface of the resilient part 40A and an upper surface of the engagement part 40B are flush with the upper surface of the frame 32. The resilient part 40A is formed in an arc shape whose diameter is less than that of the frame 32. A radially-inward end of the engagement part 40B is formed as an arc-shaped recess whose center in thickness direction is concaved radially outwardly. The recess of the engagement part 40B is formed symmetrically with respect to a symmetrical axis passing through the center in the thickness direction. The third holding member 40 is fixed to the frame 32 such that the engagement member 40B is located radially inward of the holder mounting part 35 opposed thereto. The third holding member 40 is attached to the frame 32 such that, when the holder 30 is mounted to each of the first opening 20C and the second opening 20D of the pallet body 20, the symmetrical axis of the engagement part 40B and the axis of the pallet body 20 are located on the same plane. Since the third holding member 40 has an arc shape, the engagement part 40B can be displaced radially outwardly by bending the resilient part 40A.

In this embodiment, the lens holding mechanism 42 is configured to hold a lens at three points by the first holding member 36, the second holding member 38 and the third holding member 40. Alternatively, the lens holding mechanism may be configured to hold a lens at four or more points.

As shown in FIG. 2, the frame 32 is placed inside each of the first opening 20C and the second opening 20D, while the pair of holder mounting parts 34, 35 are adjusted to come into contact with the magnets 26 as the pallet-side mounting parts, respectively. Thus, the holder mounting parts 34, 35 are attracted and held by the magnets 26, so that the holder 30 can be demountably mounted to each of the first opening 20C and the second opening 20D. In this state, the through-thickness centers (symmetrical axes) of the engagement parts 36B, 38B, 40B are located at the same height position as that of the axis of the pallet body 20.

Returning to FIG. 1, the turning device 12 comprises a coupling part 12A to be turned by a motor. The plurality of pallets 16 are arranged circumferentially side-by-side such that oblique sides of any adjacent two of the pallet bodies 20 extend parallel to each other, so as to form an umbrella shape (regular polygonal pyramid shape). In each of the pallets 16, the shaft part 22A of the first shaft member 22 is rotatably held by the coupling part 12A. The turning device 12 is configured to turn the coupling part 12A, thereby turning the plurality of pallets 16 arranged circumferentially side-by-side, about a central axis thereof.

The inverting device 14 is a device for inverting each of the pallets 16. For example, the inverting device 14 may comprise a gear. In this case, the pallet 16 can be inverted by rotating this gear while meshing the gear with the gear part 24A of the second shaft member 24 of the pallet 16. The plurality of pallets 16 can be sequentially inverted by synchronizing the turning device 12 with the inverting device 14.

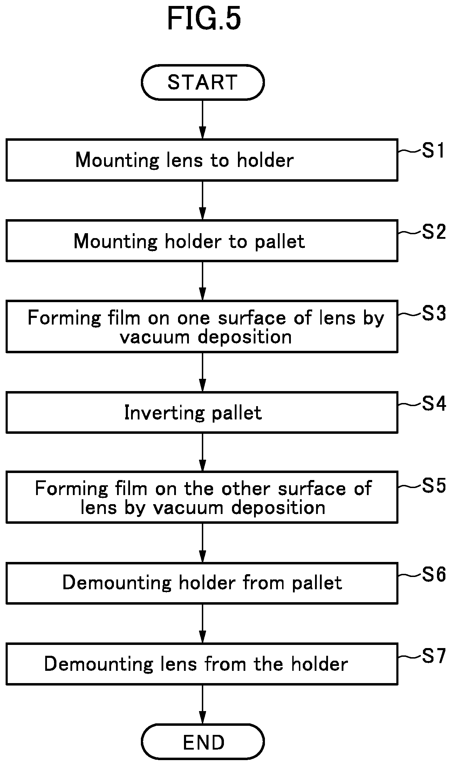

Next, a method of subjecting a lens to a film forming process by the vapor deposition apparatus according to the first embodiment will be described. FIG. 5 is a flowchart showing the flow of the operation of subjecting a lens to a film forming process by the vapor deposition apparatus according to the first embodiment.

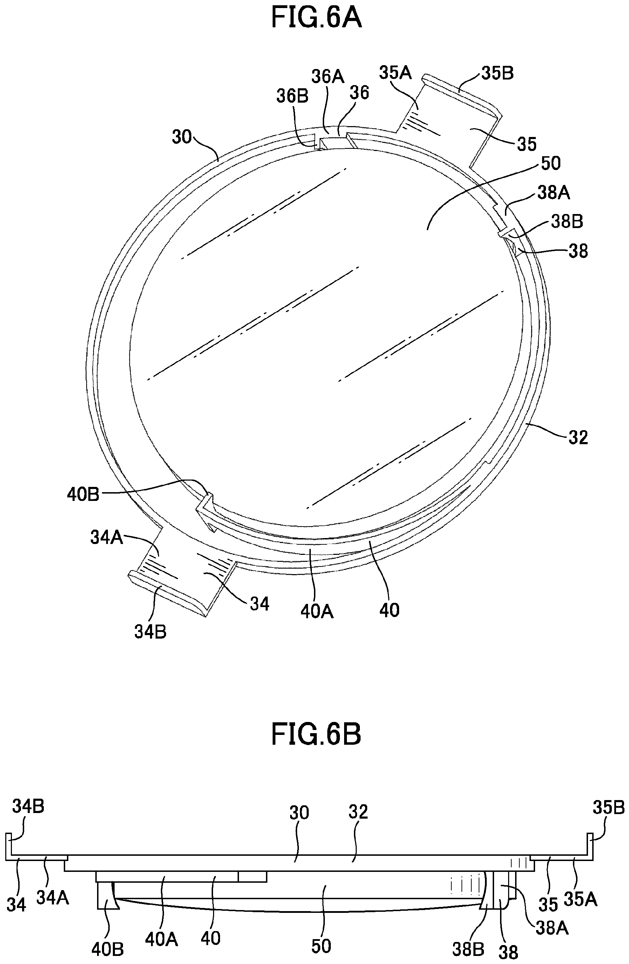

In the operation of subjecting a lens to a film forming process, first of all, a lens (optical element) whose front and back surfaces are formed, respectively, in given shapes is mounted to the holder 30 (S1: optical element mounting step). FIG. 6A and FIG. 6B are, respectively, a perspective view and a side view each enlargedly showing a state in which the lens is mounted to the holder illustrated in FIG. 2. When mounting the lens 50 to the holder 30, the engagement part 40B of the third holding member 40 is first biased radially outwardly to bend the resilient part 40A. In this state, a side surface of the lens 50 is brought into contact with the recesses of the engagement parts 36B, 38B of the first and second holding members 36, 38. Then, the pressing or biasing force applied to the third holding member 40 is released. Thus, the engagement part 40B of the third holding member 40 is brought into contact with the side surface of the lens 50, so that the lens 50 is supported by the engagement parts 36B, 38B, 40B of the first holding member 36, the second holding member 38 and the third holding member 40. On this occasion, the lens 50 is set in a posture where the through-thickness center thereof is located at centers in thickness direction of the engagement parts 36B, 38B, 40B.

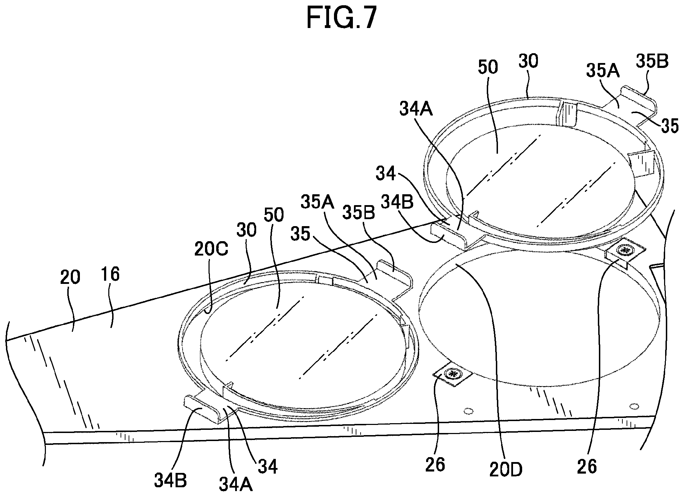

Subsequently, the holder 30 is mounted to the pallet 16 (S2: (first) holder mounting step). FIG. 7 is a perspective view showing how the holder is mounted to the pallet in the vapor deposition apparatus according to the first embodiment of the present disclosure. As shown in FIG. 7, for the operation of mounting the holder 30 to the pallet 16, it is only necessary to place the frame 32 inside each of the first opening 20C and the second opening 20D, while adjusting the pair of holder mounting parts 34, 35 to come into contact with the magnets 26, respectively. Thus, the holder mounting parts 34, 35 are attracted and held by the magnets 26, so that the holder 30 is mounted to each of the first opening 20C and the second opening 20D. In the state in which the holder 30 is mounted to the pallet 16 as just described, the axis of the shaft part 22A of the pallet 16 is located on a through-thickness central plane of the lens 50. The operation of mounting the holder 30 to the pallet 16 may be performed from above the pallet 16, or may be performed from below the pallet 16.

After mounting the holder 30 to each of the plurality of pallets 16, a film is formed on a first one of the front and back surfaces of each of the lenses 50 by vacuum vapor deposition (S3: first film forming step). Specifically, the vapor deposition material is heated and vaporized by the material vaporization device, while the pallets 16 are turned circumferentially at a constant velocity by the turning device 12. Then, an ion beam is emitted from the ion gun 6 toward the pallets 16 through the vaporized vapor deposition material. Thus, the vapor deposition material is adhered to the first surface of each of the lenses 50 held by the holders 30 mounted to each of the pallets 16, so that a thin film is formed on the first surface of the lens 50.

Subsequently, the pallets 16 are sequentially rotated 180 degrees (inverted) about the axis thereof by the inverting device 14 (S4: pallet inverting step).

After inverting all the pallets 16, a film is formed on the other, second, surface of each of the lenses 50 by vacuum vapor deposition (S5: second film forming step). The film forming process for the second surface of the lens 50 may be performed in a similar manner to the film forming process (S3) for the first surface of the lens 50.

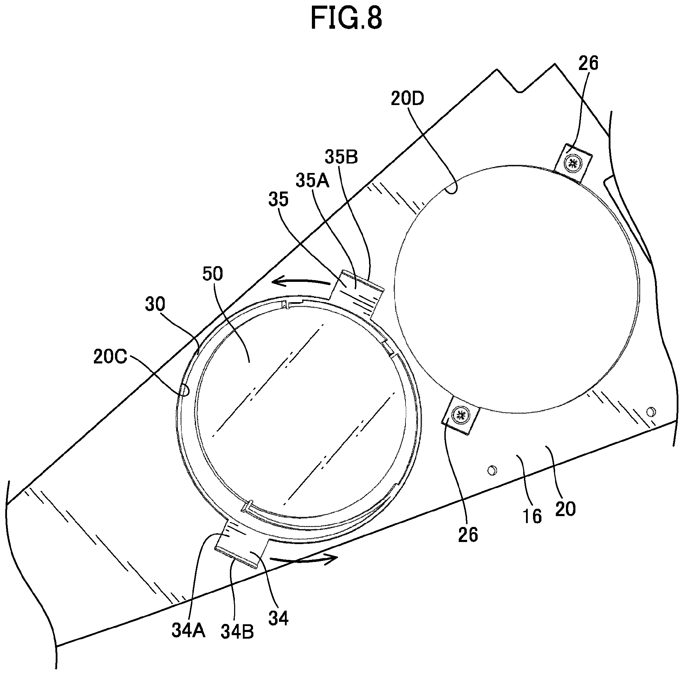

After completion of the film forming process for the second surface of each of the lenses 50, the turning device 12 is stopped, and the holders 30 are demounted from the pallets 16 (S6). FIG. 8 is a plan view showing how the holder is demounted from the pallet in the vapor deposition apparatus according to the first embodiment of the present disclosure. As shown in FIG. 8, in the operation of detaching the holder 30 from the pallet 16, the manipulatable portions 34B, 35B of the holder mounting parts 34, 35 are pushed in a circumferential direction of the frame 32 to turn the holder 30. Thus, the pair of holder mounting parts 34, 35 of the holder 30 is separated from the pair of magnets 26, and a magnetic attractive holding force therebetween weakens, so that the holder 30 can be demounted from the pallet 16. That is, the demounting operation can be easily performed by turning the holder 30 to cause a relative displacement between the two magnetic materials so as to release the magnetic attractive holding force therebetween. Before the operation of detaching the holder 30 from the pallet 16, the pallet 16 may be inverted by the inverting device 14. This makes it possible to perform the demounting operation from the same side as that on which the operation of mounting the holder 30 to the pallet 16 is performed.

Since the magnetic attractive force is sufficient against the gravity during the film forming step, dropping of the lens holder can be suppressed. On the other hand, the detaching operation can be performed by a relatively small force, because the holder 30 is turned in a direction perpendicular to the vector of the magnetic attractive holding force.

Subsequently, the lens 50 is demounted from each of the holders 30 (S7). In the operation of demounting the lens 50 from the holder 30, it is only necessary to bias the engagement part 40B of the third holding member 40 radially outwardly. Thus, the lens 50 is separated from the engagement parts 36B, 38B, 40B, so that the lens 50 can be demounted.

The following advantageous effects are achieved by the first embodiment.

In the first embodiment, the holder 30 is mounted to the pallet 16 by attracting and holding the holder mounting parts 34, 35 of the holder 30 by means of magnetism of the magnets 26 of the pallet 16. This makes it possible to easily and reliably mount the holder 30 to the pallet 16 just by placing the holder 30 in each of the first and second openings 20C, 20D of the pallet 16 in a given posture. Further, in the first embodiment, the holder 30 is mounted to the pallet 16 by means of magnetism as just described. Thus, this method is free from friction caused by screwing or deformation of a resilient member, so that it is possible to prevent dust generation due to foreign substances such as an adhered vapor deposition material.

In the first embodiment, the holder 30 comprises the manipulatable portions 34B, 35B each extending in a direction intersecting the surface of the pallet 16 in a state in which the holder 30 is mounted to the pallet 16. Thus, the holder mounting parts 34, 35 can be separated from the magnets 26 by turning the manipulatable portions 34B, 35B, so that it is possible to demount the holder 30 easily in a short time without the need for large force.

In the first embodiment, the axis of the pallet 16 passes through the central plane in thickness direction of the lens 50 held by the holder 30. Thus, supposing that the pallet 16 is inverted, a distance between the first surface of the lens 50 and the material vaporization device 8 or the ion gun 6 in the first vapor deposition step can be equalized to a distance between the second surface of the lens 50 and the material vaporization device 8 or the ion gun 6 in the second vapor deposition step, so that it is possible to subject the front and back surfaces of the lens 50 to a uniform film forming process.

### < Second Embodiment >

In the first embodiment, the vapor deposition apparatus comprises the inverting device 14, and is operable, after completion of the film forming process for one surface of a lens, to invert the pallet by the inverting device 14, and subject the other surface of the lens to a film forming process. However, the present disclosure is not limited thereto. For example, the present disclosure is applicable even to a case where the vapor deposition apparatus is not equipped with the inverting device, i.e., is incapable of inverting the pallet. The following description will be made about a second embodiment in which the vapor deposition apparatus is not equipped with the inverting device, i.e., is incapable of inverting the pallet. It should be noted here that a similar element or component to that in the first embodiment is assigned with the same reference sign, and its detailed description will be omitted.

A vapor deposition apparatus according to the second embodiment is different from the vapor deposition apparatus 1 according the first embodiment, in that it is not equipped with the inverting device 14. In connection with this, the second shaft member 24 of the pallet 16 becomes unnecessary, and the first shaft member 22 of the pallet 16 does not need to be rotatable with respect to the coupling part 12A of the turning device 12.

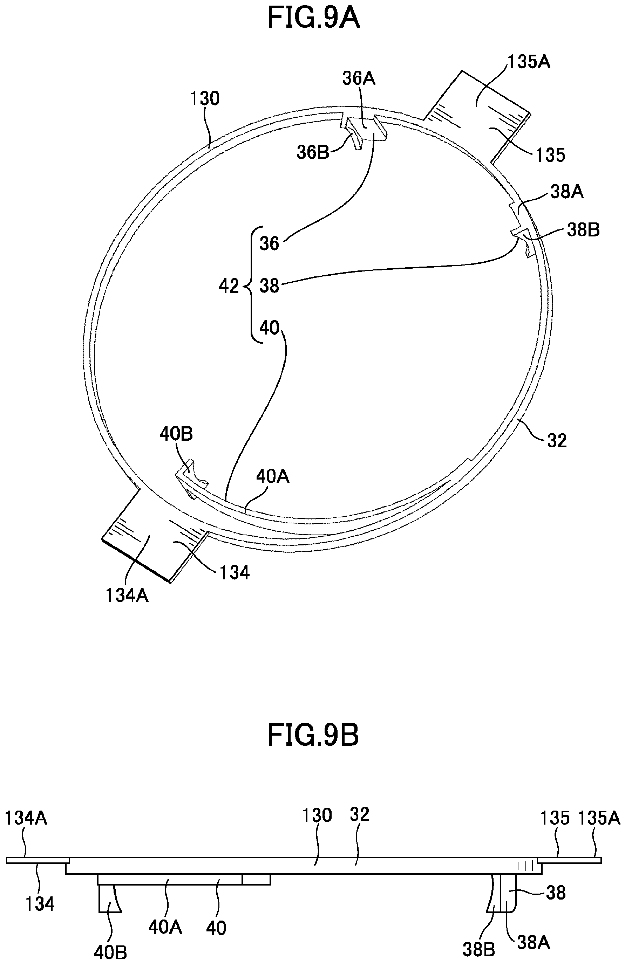

Further, the vapor deposition apparatus according to the second embodiment is different from the vapor deposition apparatus 1 according the first embodiment, in terms of the configuration of the holder. FIG. 9A and FIG. 9B are, respectively, a perspective view and a side view each enlargedly showing a holder to be used in the vapor deposition apparatus according to the second embodiment. As shown in FIGS. 9A and 9B, in the holder in the second embodiment is different from the first embodiment in that each of the holder mounting parts does not have the manipulatable portion, i.e., is composed only of the flat portion.

Specifically, the holder 130 in the second embodiment comprises a circular annular-shaped frame 32, a pair of holder mounting parts 134, 135 each projectingly provided on a radially outer surface of the frame 32, and a lens holding mechanism 42. The configurations of the lens holding mechanism 42 and the frame 32 are similar to those in the first embodiment.

The holder 130 is formed of a magnetic material or a magnet-attractable material (material attractable by a magnet), such as SUS 430. It should be noted here that, although the holder 130 in the second embodiment is entirely formed of a magnetic material, it is only necessary to form at least the holder mounting parts 134, 135 using a magnetic material.

The pair of holder mounting parts 134, 135 are provided on an outer peripheral surface of the frame 32 at respective positions opposed to each other across the center of the frame 32. Each of the holder mounting parts 134, 135 consists of a flat portion 134A, 135A having a surface which extends flatly in a radial direction of the frame 32. The flat portion 134A, 135A is formed such that an upper surface (upper surface in FIG. 9B) thereof is flush with an upper surface of the frame 32.

Preferably, a distance between a lower surface (lower surface in FIG. 9A) of the flat portion 134A, 135A and a center in thickness direction of each engagement part 36B, 38B, 40B is one half of the thickness of a pallet body 20 of each of a plurality of pallets 16. Thus, irrespective of whether the holder 130 is mounted from above an upper surface of the pallet body 20 or mounted from below a lower surface of the pallet body 20, a through-thickness center of a lens 50 will be located at the height position of a through-thickness center of the pallet body 20.

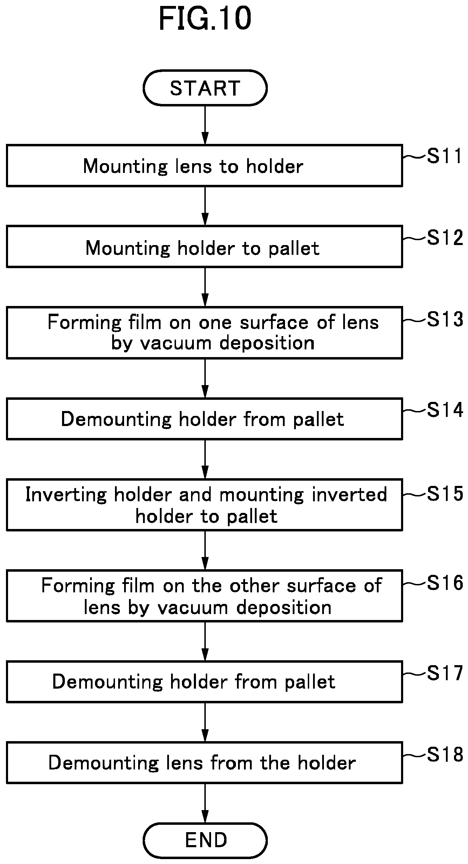

Next, a method of subjecting a lens to a film forming process by using the vapor deposition apparatus according to the second embodiment will be described. FIG. 10 is a flowchart showing the flow of the operation of subjecting a lens to a film forming process by the vapor deposition apparatus according to the second embodiment.

In the operation of subjecting a lens to a film forming process, first of all, a lens (optical element) whose front and back surfaces are formed, respectively, in given shapes is mounted to the holder 130 (S11: optical element mounting step). The operation of mounting the lens to the holder 130 may be performed in a similar manner to that in the first embodiment.

Subsequently, the holder 130 with the lens 50 is mounted to each of the pallets 16 (S12: first holder mounting step). For the operation of mounting the holder 130 to the pallet 16, it is only necessary to place the frame 32 inside each of a first opening 20C and a second opening 20D, while adjusting the pair of holder mounting parts 134, 135 to come into contact with a pair of magnets 26, respectively. Thus, the holder mounting parts 134, 135 are attracted and held by the magnets 26, so that the holder 130 is mounted to each of the first opening 20C and the second opening 20D. In the state in which the holder 130 is mounted to the pallet 16 as just described, the axis of a shaft part 22A of the pallet 16 is located on a central plane in thickness direction of the lens 50. The operation of mounting the holder 130 to the pallet 16 may be performed from above the pallet 16, or may be performed from below the pallet 16.

After mounting the holder 130 to each of the plurality of pallets 16, a film is formed on a first one of the front and back surfaces of each of the lenses 50 by vacuum vapor deposition (S13: first film forming step). Specifically, a vapor deposition material is heated and vaporized by a material vaporization device 8, while the pallets 16 are turned circumferentially at a constant velocity by a turning device 12. Then, an ion beam is emitted from an ion gun 6 toward the pallets 16 through the vaporized vapor deposition material. Thus, the vapor deposition material is adhered to the first surface of each of the lenses 50 held by the holders 130 mounted to each of the pallets 16, so that a thin film is formed on the first surface of the lens 50.

After completion of the film forming process for the first surface of each of the lenses 50, the turning device 12 is stopped, and the holders 130 are demounted from the pallets 16 (S14: holder demounting step). In the operation of demounting the holder 130 from the pallet 16, it is only necessary to turn the holder 130 with respect to the pallet 16, as with the first embodiment.

Subsequently, after inverting the holder 130, the inverted holder is mounted to the pallet 16 (S15: second holder mounting step). Thus, the holder 130 is mounted in a state in which the other, second, surface of the lens 50 faces downwardly.

After demounting and inverting all the holders 130, a film is formed on the second surface of each of the lens 50 by vacuum vapor deposition (S16: second film forming step). The film forming process for the second surface of the lens 50 may be performed in a similar manner to the film forming process for the first surface of the lens (S13).

After completion of the film forming process for the second surface of each of the lenses 50, the turning device 12 is stopped, and the holders 130 are demounted from the pallets 16 (S17). In the operation of demounting the holder 130 from the pallet 16, it is only necessary to turn the holder 130 with respect to the pallet 16, as with the first embodiment,

Subsequently, the lens 50 is demounted from each of the holders 130 (S18). The demounting of the lens 50 may be performed in a similar manner to that in the first embodiment.

The following advantageous effects are achieved by the second embodiment.

In the second embodiment, the holder 130 is mounted to the pallet 16 by attracting and holding the holder mounting parts 134, 135 of the holder 130 by means of magnetism of the magnets 26 of the pallet 16, as with the first embodiment, so that it is possible to easily mount the holder 130 to the pallet 16, and prevent dust generation due to the vapor deposition material.

In the second embodiment, each of the holder mounting parts 134, 135 is formed as the flat portion 134A, 135A having a flat surface, so that it is possible to, after subjecting one surface of a lens 50 to a film forming process, invert the demounted holder 130, and re-mount the inverted holder 130 so as to subject the other surface of the lens to a film forming process. This makes it possible to easily perform the operation of inverting the holder 130 even when using a vapor deposition apparatus equipped with no existing inverting device.

In the above embodiments, a magnet is used as the pallet-side mounting part, and the holder mounting part is formed of a magnetic material or a magnet-attractable material. Alternatively, the pallet-side mounting part may be made of a magnetic material, and the holder mounting part is composed of a magnet. In other words, the holder mounting part may be formed of one of a magnet and a magnetic material, and the pallet-side mounting part corresponding to the holder mounting part may be formed of a remaining one of the magnet and the magnetic material.

Although the above embodiments have been described based on an example where the holder and the lens holding device are used in vacuum vapor deposition, a vapor deposition method is not limited to vacuum vapor deposition. Further, a film forming method is not limited to vapor deposition, but the holder and the lens holding device may be applied to sputtering film formation. Further, a target of film formation is not limited to a lens, but the present disclosure may be applied to a wide variety of optical elements.

As used in this specification, the terms "one of a magnet and a magnet-attractable material" and "a remaining one of the magnet and the magnet-attractable material" mean that each of the one and the remaining one comprises a magnetic material, and includes a case where each of the one and the remaining one is a magnet

The present invention can be usefully applied to an optical element such as an optical lens. In particular, it is advantageous to an optical element made of plastic, such as a spectacle lens. For example, a film forming process using the present invention may be applied to a semifinished product after being formed preferably using a resin such as polycarbonate, thiourethane or methacrylate and before being formed in a frame shape.

In manufacturing of a spectacle lens, the curve of each of a convex surface and a concave surface of the lens varies a good deal according to a prescribed lens power, and the thickness and weight of the lens also vary according to selection of a material depending on refractive index. Although there are different types of lenses in terms of diameter or shape, the present invention can be suitably applied to any of them.

### LIST OF REFERENCE SIGNS

- 1:: vapor deposition apparatus
- 2:: chamber
- 4:: vacuum pump
- 6:: ion gun
- 8:: material vaporization device
- 10:: lens holding device
- 12:: turning device
- 12A:: coupling part
- 14:: inverting device
- 16:: pallet
- 20:: pallet body
- 20A:: first mounting part
- 20B:: second mounting part
- 20C:: first opening
- 20D:: second opening
- 20F:: recess
- 22:: first shaft member
- 22A:: shaft part
- 24:: second shaft member
- 24A:: gear part
- 26:: magnet
- 30:: holder
- 32:: frame
- 34:: holder mounting part
- 34A:: flat portion
- 34B:: manipulatable portion
- 35:: holder mounting part
- 35A:: flat portion
- 35B:: manipulatable portion
- 36:: first holding member
- 36A:: attachment part
- 36B:: engagement part
- 38:: second holding member
- 38A:: attachment part
- 38B:: engagement part
- 40:: third holding member
- 40A:: resilient part
- 40B:: engagement part
- 42:: lens holding mechanism
- 50:: lens
- 130:: holder
- 134:: holder mounting part
- 134A:: flat portion
- 135:: holder mounting part
- 135A:: flat portion

## Claims

1. An optical element holder for holding an optical element, comprising:
a holder body;
an optical element holding part provided on the holder body and configured to hold the optical element; and
a holder mounting part provided on the holder body and formed of one of a magnet and a magnet-attractable material,
wherein the optical element holder is attachable to a pallet comprising a pallet-side mounting part formed of other of the magnet and the magnet-attractable material, by a magnetic force between the holder mounting part and the pallet-side mounting part.

2. An optical element holding device comprising:
a holder body configured to hold an optical element and provided with a holder mounting part formed of one of a magnet and a magnet-attractable material; and
a pallet-side mounting part formed of other of the magnet and the magnet-attractable material, to allow the holder body to be attached thereto by a magnetic force.

3. An optical element holding device comprising:
the optical element holder according to claim 1; and
a pallet comprising a pallet-side mounting part formed of the other of the magnet and the magnet-attractable material.

4. The optical element holding device according to claim 3, wherein the optical element holder has a manipulatable portion which extends in a direction intersecting a surface of the pallet in a state in which the optical element holder is mounted to the pallet.

5. The optical element holding device according to claim 3 or 4, wherein the pallet is configured to be invertible, and further comprises an inverting mechanism for inverting the pallet about an axis of the pallet, wherein the axis of the pallet passes through a central plane in a thickness direction of the optical element held by the optical element holder.

6. The optical element holding device according to claim 3 or 4, wherein the holder mounting part is formed such that front and back surfaces thereof are flat.

7. A film forming apparatus comprising the optical element holding according to any one of claims 3 to 6.

8. A vapor deposition apparatus for applying vapor deposition to a surface of an optical element, comprising:
the optical element holding device according to claims 3 to 6; and
a vaporization device for vaporizing a vapor deposition material.

9. A method of forming a desired film on a surface of an optical element by using an optical element holding device,
wherein the optical element holding device comprises: an optical element holder comprising a holder body, an optical element holding part provided on the holder body and configured to hold the optical element, and a holder mounting part provided on the holder body and formed of one of a magnet and a magnet-attractable material; and a pallet comprising a pallet-side mounting part formed of other of the magnet and the magnet-attractable material, the method comprising:
an optical element mounting step of mounting the optical element to the holder by the optical element holding part;
a first holder mounting step of mounting the holder to the pallet by a magnetic force between the holder mounting part and the pallet-side mounting part; and
a first film forming step of applying film forming process to the optical element.

10. The method according to claim 9, which further comprises, subsequent to the first film forming step:
a pallet inverting step of inverting the pallet to which the holder is mounted; and
a second film forming step of applying a film forming process to the optical element.

11. The method according to claim 9, which further comprises, subsequent to the first film forming step:
a holder demounting step of demounting the holder from the pallet;
a second holder mounting step of mounting the holder the optical element of which have been inverted, to the pallet by a magnetic force between the holder mounting part and the pallet-side mounting part; and
a second film forming step of applying a film forming process to the optical element.

12. The method according to any one of claims 9 to 11, wherein the film forming process is a vapor deposition process.
